**Europäisches Patentamt**

**European Patent Office**

**Office européen des brevets**

(19)

(11) Veröffentlichungsnummer: **0 016 307**
**B1**

(12) EUROPÄISCHE PATENTSCHRIFT

(45) Veröffentlichungstag der Patentschrift:
04.11.81

(21) Anmeldenummer: 80100192.6

(22) Anmeldetag: 16.01.80

(51) Int. Cl.³: **C 03 C 27/00**, B 32 B 17/00,
H 01 G 4/30

(54) **Verfahren zur Herstellung einer mehrschichtigen glaskeramischen Struktur mit innen liegenden Versorgungsleitungen auf Kupferbasis.**

(30) Priorität: 23.03.79 US 23112

(43) Veröffentlichungstag der Anmeldung:
01.10.80 Patentblatt 80/20

(45) Bekanntmachung des Hinweises auf die Patenterteilung:
04.11.81 Patentblatt 81/44

(84) Benannte Vertragsstaaten:
AT BE DE FR GB

(56) Entgegenhaltungen:
US-A-3 604 092
US-A-3 902 102
US-A-4 101 952

(73) Patentinhaber: International Business Machines
Corporation, Armonk, N.Y. 10504 (US)

(72) Erfinder: Herron, Lester Wynn, Dartantra Drive, Hopewell
Junction, NY 12533 (US)
Erfinder: Master, Raj Navinchandra, 8 Split Tree Drive,
Wappingers Falls, NY 12590 (US)
Erfinder: Tummala, Rao Ramamahara, 20 Split Tree Drive,
Wappingers Falls, NY 12590 (US)

(74) Vertreter: Böhmer, Hans Erich, Dipl.-Ing. et al,
Schönaicher Strasse 220, D-7030 Böblingen (DE)

## Verfahren zur Herstellung einer mehrschichtigen glaskeramischen Struktur mit innen liegenden Versorgungsleitungen auf Kupferbasis

Die Erfindung betrifft ganz allgemein die Herstellung von glaskeramischen Substraten als Träger für Halbleiterbauelemente oder für mit integrierten Schaltungen versehene Schaltungsplättchen und insbesondere für in Dickschicht-Technik, aufgebaute, mehrschichtige Substrate aus gesinterten, glaskeramischen Isolierschichten und dazwischen liegenden Leitungsmustern auf Kupferbasis. Die Erfindung betrifft ferner Verfahren und Materialien zur Herstellung derartiger Substrate, die von bestimmten pulverisierten kristallisierbaren Gläsern und leitenden Pasten ausgehen, die Kupfer in Form von fein zerteiltem Pulver enthalten, durch Herstellen sogenannter laminierter grüner Folien, bei Brenntemperaturen unterhalb des Schmelzpunktes von Kupfer. Die Substrate können dabei mit Anschlußkontakten für die Befestigung von Halbleiterplättchen, von Anschlußleitungen, Kondensatoren, Widerständen, Abdeckkapseln und dergleichen versehen sein. Die Verbindung der einzelnen Metallisierungs-Leitungsebenen miteinander kann durch sogenannte durchgehende Bohrungen hergestellt werden, indem man in den einzelnen glaskeramischen Schichten vor der Laminierung Bohrungen herstellt und mit der metallischen Paste ausfüllt, so daß nach dem Sintervorgang sich eine dichte metallische Verbindung zwischen den einzelnen, auf Kupferbasis aufgebauten Metallisierungsebenen ergibt.

Aufgabe der Erfindung ist die Herstellung mehrschichtiger glaskeramischer Substrate, die mit der Technik dicker Schichten von Leitern auf Kupferbasis verträglich ist und zusammen mit diesen Leitern gebrannt werden können. Insbesondere sollen diese mehrschichtigen Substrate aus glaskeramischen Schichten innen liegende Leitungsmuster auf Kupferbasis enthalten und dabei als Träger für Halbleiterbauelemente, Halbleiterplättchen und dergleichen dienen, mit den entsprechenden Anschlüssen für die Halbleiterplättchen an die Leitungsmuster der verschiedenen Ebenen des als Träger dienenden Substrats.

### Stand der Technik

Im Hinblick auf die hohen Packungsdichten, die sich mit mehrschichtigen, keramischen, mit innen liegenden Leiterzügen versehene Strukturen erreichen lassen, haben diese Strukturen für die Packung von mit integrierten Schaltungen versehenen Halbleitern und anderen Bauelemente in der Elektronikindustrie umfangreiche Anwendung gefunden. Dies geht insbesondere aus den US-Patentschriften 3 379 943, 3 502 520 und 4 080 414 hervor.

Ganz allgemein gesprochen werden solche üblichen keramischen Strukturen aus keramischen grünen, d. h. ungebrannten Folien hergestellt, die aus keramischen Massen gefertigt werden durch Mischen keramischer Teilchen, eines thermoplastischen Polymeren (z. B. Polyvinylbutyral) und einem Lösungsmittel. Diese Grundmasse wird dann zu keramischen grünen Folien ausgebreitet oder ausgegossen, die Lösungsmittel werden danach ausgetrieben, so daß man zusammmenhängende, selbsttragende, biegsame grüne Folien erhält, die schließlich zum Austreiben des Harzes gebrannt werden, worauf die einzelnen keramischen Teilchen zu einem dichten keramischen Substrat zusammen sintern.

Bei der Herstellung mehrschichtiger Strukturen dieser Art wird beispielsweise durch Sprühen, Tauchen, durch Siebdruck und dergleichen, ein elektrisches Leitungsmuster auf die dafür vorgesehenen grünen Folien aufgebracht, die später Teilschichten der gewünschten mehrschichtigen Struktur bilden. Diese Folien können dabei durchgehende Bohrungen aufweisen, wie sie nachher bei der letzlich hergestellten Struktur für die Verbindung zwischen den einzelnen Metallisierungsebenen erforderlich sind. Die erforderliche Anzahl von einzelnen grünen Folien wird in der gewünschten Reihenfolge übereinander gestapelt und miteinander ausgerichtet. Dieser Stapel grüner Folien wird dann bei den notwendigen Temperaturen und Drücken soweit zusammengepreßt, daß sich eine Bindung zwischen benachbarten Schichten ergibt, soweit sie nicht durch die die elektrischen Leiter bildenden Leitungsmuster voneinander getrennt sind. Dieses aus grünen Folien bestehende Laminat wird dann zum Austreiben des Bindemittels und zur Sinterung der keramischen Teilchen und der Metallteilchen zu einer keramischen dielektrischen Struktur mit den gewünschten Mustern von elektrischen Leitungen im Innern gebrannt.

Tonerde, d. h. Aluminiumoxid ($Al_2O_3$), hat wegen seiner ausgezeichneten Isoliereigenschaften, Wärmeleitfähigkeit, Stabilität und Festigkeit bei der Herstellung solcher Substrate als Substratmaterial weite Verwendung gefunden. Für viele Hochleistungsanwendungsgebiete hat die relativ hohe Dielektrizitätskonstante von Tonerde (annähernd 10) wesentliche Signallaufzeitverzögerungen und Rauschen zur Folge. Ein weiterer Nachteil von Aluminiumoxid ist sein relativ hoher Wärmeausdehnungskoeffizient (ungefähr 65 bis $70 \times 10^{-7}/°C$) verglichen mit dem der Silicium-Halbleiterplättchen (25 bis $30 \times 10^{-7}/°C$), was in manchen Fällen bei Entwurf und Zuverlässigkeitsbetrachtungen zu Schwierigkeiten führen kann, insbesondere dann, wenn ein Siliciumplättchen an Lötstützpunkten mit dem Substrat verbunden werden soll.

Ein besonderer Nachteil von handelsüblichem Aluminiumoxid liegt in seiner hohen Sinter- und Brenntemperatur (annähernd 1600°C), die die Auswahl gemeinsam damit sinterbarer Metalle auf feuerfeste Metalle, wie z. B. Wolfram, Molybdän, Platin, Palladium oder eine Kombination dieser Metalle miteinander, oder mit bestimmten anderen Metallen beschränkt, was die ausschließliche Verwendung so guter elektrischer Leiter, wie z. B. Gold, Silber oder Kupfer ausschließt, da diese bereits geschmolzen sind, ehe die Sintertemperatur von Aluminiumoxid erreicht ist.

In der gleichzeitig mit dieser Europäischen Patentanmeldung eingereichten Europäischen Patentanmeldung, die der US-Patentanmeldung Nr. 875 703 vom 6. Februar 1978 entspricht, ist eine mehrschichtige glaskeramische Struktur offenbart, durch die die Nachteile von keramischen Strukturen aus Aluminiumoxid beseitigt werden. Die dort offenbarten mehrschichtigen glaskeramischen Strukturen sind durch eine niedrige Dielektrizitätskonstante und dadurch ausgezeichnet, daß sie mit in Dickschicht-Technik aufgebauten Schaltungen aus Gold, Silber oder Kupfer verträglich sind und gleichzeitig mit diesen gebrannt werden können.

Von den beiden Arten glaskeramischer Materialien, die in dieser US-Patentanmeldung offenbart sind, enthält die eine Beta-Spodumen, $Li_2O \cdot Al_2O_3 \cdot 4 SiO_2$ als hauptsächliche kristalline Phase, während die andere, Cordierit, $2 MgO \cdot 2 Al_2O_3 \cdot 5 SiO_2$ als hauptsächliche kristalline Phase enthält. Ein gemeinsames Merkmal dieser gesinterten glaskeramischen Materialien ist unter anderem ihre ausgezeichnete Sinterbarkeit und Kristallisation unterhalb von 1000° C.

Es wurde jedoch festgestellt, daß Silber zu Elektromigration neigt, und man vermutet auch eine Diffusion in das glaskeramische Material.

Obgleich bereits mit Erfolg glaskeramische Substrate unter Verwendung von Gold für die Metallisierung (spezifischer Widerstand von etwa 3,75 Mikroohm-Zentimeter) hergestellt wurden, so ist Gold doch außergewöhnlich teuer, so daß aus wirtschaftlichen Gründen die Auswahl auf Kupfer als praktische Alternative beschränkt ist. Außerdem ist anzumerken, daß dabei jede Legierungsbildung als Nachteil eine Zunahme im spezifischen Widerstand zur Folge hätte.

Die Verwendung von Kupfer in der Dickschicht-Technik ist relativ neu. Da Kupfer zu Oxidation neigt, ist es notwendig, mehrschichtige Strukturen in einer reduzierenden oder neutralen Atmosphäre zu sintern. Da jedoch bei reduzierenden Atmosphären Adhesionsprobleme auftreten können, sind neutrale Atmosphären vorzuziehen. In einem typisch industriellen Zyklus zum Sintern dicker Kupferschichten auf einem vorgebrannten, aus Aluminiumoxid bestehenden Substrat würde mit einer Geschwindigkeit von 50° C bis 70° C je Minute der Brenn- oder Sinterbereich von 900° C bis 950° C erreicht, dann würde diese höchste Temperatur für 15 Minuten eingehalten, worauf eine Abkühlung mit einer Geschwindigkeit von 50° C bis 70° C je Minute durchgeführt würde.

Bei der Herstellung von mehrschichtigen glaskeramischen Strukturen können Schwierigkeiten bei der Verwendung von Bindemitteln auftreten, die solche Bindemittel ausschließen, die man sonst bei üblichen Herstellungsverfahren einsetzt. Es wurde beispielsweise festgestellt, daß das Bindemittel Polyvinylbutyral in einer nicht oxidierenden Atmosphäre unterhalb von 1150°C nicht leicht vollständig entfernt werden kann. Für das Austreiben eines Bindemittels ist es außerdem erforderlich, daß der glaskeramische Körper so lange porös bleibt, bis alle Reste des Bindemittels entfernt sind.

Verwendet man glaskeramische Materialien und Kupfer für die Metallisierung, dann liegt die höchst zulässige Temperatur für das Entfernen von Bindemitteln wegen des Erweichens der Glasteilchen bei etwa 800°C bis 875°C. Somit werden nach Erweichen des Glases alle noch vorhandenen Bindemittelreste in dem Glaskörper eingefangen. Es wurde ferner festgestellt, daß Stickstoff oder jede andere neutrale oder reduzierende Atmosphäre das Austreiben oder Entfernen des Bindemittels unterhalb der Erweichungstemperatur von Glas beispielsweise bei etwa 800°C bis 875°C schwierig macht, was zu schwarzen oder dunklen Substraten führt, die nicht voll gesintert sind. Die schwarze oder dunkle Farbe wird allgemein auf Kohlenstoffreste zurückgeführt.

Ferner sind Schwierigkeiten mit verschiedenen neutralen oder reduzierenden Atmosphären aufgetreten, wie z. B. bei nassem und trockenem Stickstoff, nassem, und trockenem formierenden Gas, langen Verweilzeiten bei Temperaturen unterhalb der Fließgrenze der glaskeramischen Materialien (um nichtflüchtige Produkte einzufangen), oder abwechselnden Einsatz von Luft und formierendem Gas für eine Oxidation von Kohlenstoff und Reduktion etwa gebildeten Kupferoxids zu Kupfer ohne drastische Volumenänderungen, die sich aus der Bildung von Kupferoxid ergeben.

Versuche zur Entwicklung eines polymeren Bindemittelsystems, das durch eine Art von Fraktionierung ohne verbleibende kohlenstoffhaltige Reste ausbrennen würde, das zu keinem dunklen Substrat führen würde, ergab jedoch andere damit zusammenhängende Nachteile, obgleich die Ausbrenneigenschaften als gut zu bezeichnen waren. Beispielsweise wurde festgestellt, daß Polyalphamethystyrol und Polyisobutylen nur schlecht für die Bildung von dünnen Filmen d. h. grünen dünnen Folien, geeignet sind. Polyoxymethylen, Polyäthylen und Polypropylen neigen zum Fließen, da sie sich in den üblicherweise vorgezogenen Lösungsmitteln nicht ausreichend lösen noch sich in brauchbarer Weise ausbrennen lassen. Die der Erfindung zugrunde liegende Aufgabe wird mit den im kennzeichnenden Teil des Hauptanspruchs angegebenen Verfahrensschritten gelöst. Weitere Ausgestaltungen der Erfindung ergeben sich aus den Unteransprüchen.

Die Erfindung wird nunmehr anhand von Ausführungsbeispielen in Verbindung mit den beigefügten Zeichnungen im einzelnen näher beschrieben.

In den Zeichnungen zeigt

Fig. 1 ein Diagramm des Gleichgewichtszustandes zwischen Kupfer, Kohlenstoff und deren Oxiden in einer $H_2/H_2O$-Atmosphäre,

Fig. 2 ein Diagramm zur Darstellung des Austreibens des Bindemittels und der Blasenbildung einer glaskeramischen grünen Folie in einer $H_2/H_2O$-Atmosphäre,

Fig. 3 ein Zeitdiagramm zur Darstellung des Verlaufs eines Brennvorgangs gemäß einer Ausführungsform der Erfindung und

Fig. 4 ein Zeitdiagramm zur Darstellung des Ablaufs des Brennvorgangs gemäß einer weiteren Ausführungsform der Erfindung.

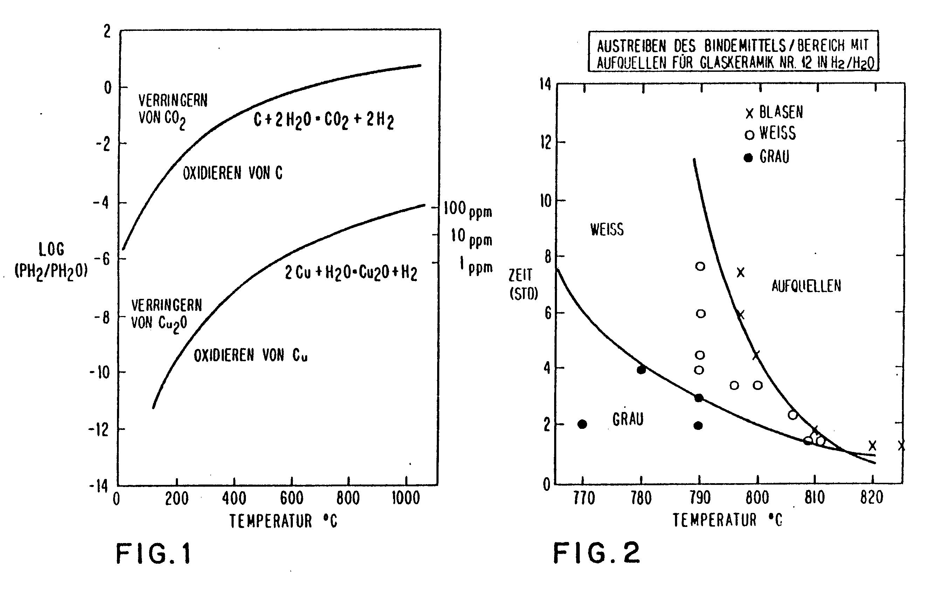

Gemäß der Erfindung wurde festgestellt, daß eine Atmosphäre aus einer Mischung von Wasserstoff ($H_2$) und Wasserdampf ($H_2O$) in bestimmten definierten Verhältnissen zur Oxidation von kohlenstoffhaltigen Resten gebrannter Polymere benutzt werden kann, während gleichzeitig die für Kupfer erforderlichen reduzierenden, bzw. neutralen Bedingungen beibehalten werden. Demgemäß wurde ein Verfahren zum Entfernen von polymeren Bindemitteln (z. B. Polyvinylbutyral) aus mehrschichtigen, aus glaskeramischen Schichten und Kupfermetallisierungen bestehenden Substraten gemäß diesem Gedanken entwickelt. In diesem Verfahren wird ein laminierter Aufbau von grünen, glaskeramischen Schichten mit innen liegenden, aus Kupfer oder auf Kupferbasis hergestellten Leitungsmustern in einer $H_2/H_2O$-Atmosphäre mit einer Geschwindigkeit von 1°C bis 3°C je Minute bis zu einer Ausbrenntemperatur von 785 ± 10°C erwärmt, zum Ausbrennen des polymeren Materials dann für etwa 3 bis 5 Stunden auf dieser Temperatur gehalten, worauf die Atmosphäre durch Stickstoff ersetzt wird und für etwa 0,5 Stunden gehalten wird, um etwa eingefangenes oder gelöstes Wasser zu entfernen, mit anschließender Erwärmung in der Stickstoffatmosphäre mit einer Geschwindigkeit von 1°C bis 3°C je Minute bis zu einer Sintertemperatur von etwa 930°C bis etwa 970°C, wobei diese Temperatur dann für zwei Stunden beibehalten wird. Während des Erwärmens auf die Ausbrenntemperatur werden die Verhältnisse von $H_2$ zu $H_2O$ in der Atmosphäre kontinuierlich von $10^{-6}$ bei 400°C bis auf $10^{-4}$ bei der Ausbrenntemperatur verändert. Diese Veränderung des Verhältnisses von $H_2$ zu $H_2O$ hält dabei die Atmosphäre ganz allgemein bei einem für die Reduktion zu Kupfer günstigen Wert, doch bleibt das Verhältnis in jedem Fall in hohem Maße und jederzeit stark oxidierend für Kohlenstoff. Durch diesen Brennzyklus für mehrschichtige, glaskeramische Strukturen kann man nunmehr die Bindemittel vollständig entfernen, während das Kupfer gleichzeitig reduziert bleibt, so daß man gute weiße Substrate mit gutem metallischem Kupfer erhält. Fig. 1 zeigt den Gleichgewichtszustand zwischen Kupfer, Kohlenstoff und deren Oxiden

unter gleichzeitiger Angabe, daß ein Mischungsverhältnis von $H_2$ und Wasserdampf ($H_2O$) mit den richtigen Werten für die Oxidation von Kohlenstoff eingesetzt werden kann, während gleichzeitig für Kupfer reduzierende oder neutrale Bedingungen aufrechterhalten werden.

Es gibt zwei Gründe für die Auswahl der Ausbrenntemperatur für das Bindemittel bei 785 ± 10°C. Wie bereits zuvor angedeutet, muß das kristallisierbare Glas beim Austreiben oder Ausbrennen der Bindemittel für die Dauer des Austreibens porös sein, damit die Bindemittel vollständig ausgetrieben werden können. Die bei dieser Temperatur noch vorhandene Porösität läßt auch die Entfernung von etwa eingefangenem oder gelöstem Wasser in dem Glas gegen das Ende der Halteperiode zu.

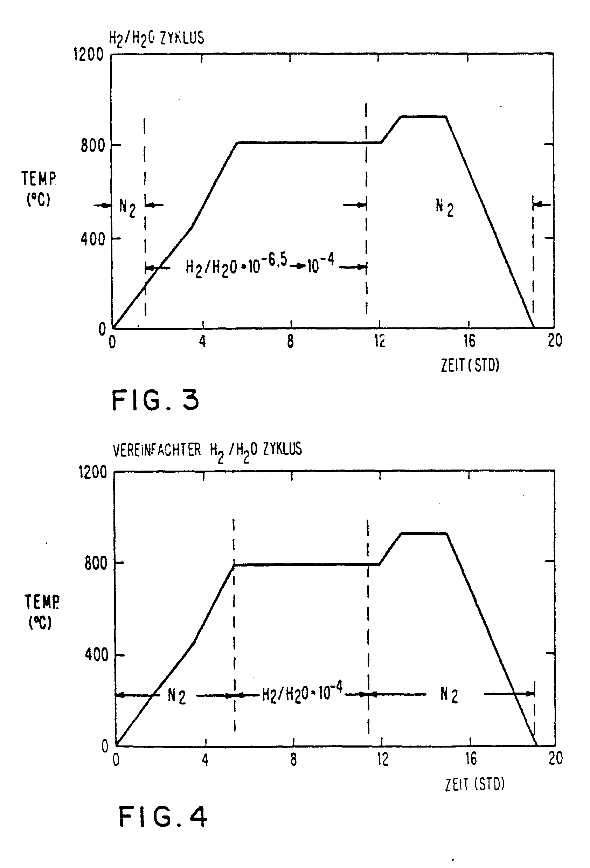

Dabei wurde ein Bereich für die Entfernung des Bindemittels über der Temperatur aus Betrachtungen der Oxidation von Kohlenstoff und den Fließeigenschaften einer kristallisierbaren Glaszusammensetzung ermittelt. Aus dem Diagramm ersieht man, daß bei zu niedrigen Temperaturen (z. B. 750°C) es prohibitiv lange dauern würde, um den Kohlenstoff zu entfernen, während bei zu hohen Haltetemperaturen Wasser und Bindemittelreste eingeschlossen werden können. Da das gelöste Wasser während des Glas-Kristall-Wachstums (nach dem Schließen der Poren) abgestoßen wird, wird es anschließend noch verbleibenden Kohlenstoff zur Bildung von Karbonoxiden und Wasserstoff oxidieren, was zu einer Ausdehnung des Substrats oder im schlimmsten Fall zum Auseinanderbrechen des Substrats führt. Dieses Anschwellen, wenn sich der glaskeramische Körper ausdehnt, statt sich beim Sintern zusammenzuziehen, läßt sich dadurch vermeiden, daß man gemäß der Erfindung vorgeht, wie dies in einem Zeitablaufschaubild in Fig. 3 für einen Brennvorgang dargestellt ist. Wie aus Fig. 3 zu ersehen, kann die laminierte grüne glaskeramische Struktur in einer inerten Atmosphäre (z. B. $N_2$) vor dem eigentlichen in der $H_2/H_2O$-Atmosphäre ablaufenden Sintervorgang auf etwa 200°C vorerwärmt werden.

Fig. 4 zeigt einen etwas abgewandelten Zeitablauf für einen Brennvorgang für ein grünes glaskeramisches Laminat mit vereinfachter Überwachung und kontinuierlicher Änderung des Verhältnisses zwischen $H_2$ und $H_2O$, damit in der Produktion die erforderlichen Verfahrensparameter eingehalten werden können. Thermogravimetrische (z. B. für Polyvinylbutyral-Bindemittel) Untersuchungen und Untersuchungen im heißen Zustand haben gezeigt, daß in Stickstoff der größte Teil des Abbaus des Bindemittels und/oder dessen Entfernung bei etwa 700°C bis 800°C erfolgt. Der Vorteil eines solchen Abbaus besteht darin, daß die Substrate in Stickstoff bis zu einer Temperatur kurz unter dem Erweichungspunkt (Tc) des kristallinen Glases gebrannt werden können mit nachfolgender Umschaltung auf eine $H_2/H_2O$-Atmosphäre zum Entfernen des restlichen Bindemittels. Damit muß bei der Brenntemperatur von 785±10°C nur ein bestimmtes Verhältnis (z. B. $10^{-4}$) von $H_2/H_2O$ benutzt werden, so daß dadurch das Verfahren vereinfacht wird, indem sowohl die Steuerung der Atmosphäre vereinfacht als auch die Herstellungskosten verringert werden.

Es wäre normalerweise zu erwarten gewesen, daß die Eigenschaften von glaskeramischen Materialien oder Schichten, wie zum Beispiel die Festigkeit (der Bruchmodul), der Wärmeausdehnungskoeffizient und die Dielektrizitätskonstante K durch die $H_2/H_2O$-Atmosphäre nachteilig beeinflußt werden könnten. Wenn man jedoch den hier angegebenen zeitlichen Ablauf des Brennvorgangs einhält, dann wird am Ende der Halteperiode (beispielsweise bei 785±10°C) jedes in der glaskeramischen Masse gelöste Wasser entfernt. Das hat zur Folge, daß sich die Eigenschaften von in $H_2/H_2O$ gebrannten glaskeramischen Materialien nicht nachteilig von denen in Luft gebrannten glaskeramischen Materialien unterscheiden, wie dies nachstehend für das Brennen oder Sintern gemäß der Erfindung mit dem unten angegebenen kristallisierbaren Glas der nachfolgenden Zusammensetzung gezeigt ist:

Zusammensetzung (in Gewichtsprozent) der Glasformel Nr. 12

| | |
|---|---|
| $SiO_2$ | 52,5 |
| $MgO$ | 22,0 |
| $Al_2O_3$ | 22,0 |
| $P_2O_5$ | 1,5 |
| $B_2O_3$ | 0,5 |
| $ZrO_2$ | 1,5 |

Nach dem Brennen gemäß der Erfindung erhält man folgende Werte:

Bruchmodul = 210 $MN/m^2$ (Meganewton je Quadratmeter)
Wärmeausdehnungskoeffizient TCE = $18 \times 10^{-7}/°C$
K Dielektrizitätskonstante = 5,0 (bei 1000 Hz).

Handelsübliche gebrannte Kupferpasten haben spezifische Widerstanswerte von 2,5 bis 4 Mikroohm-cm. Dieses Kupfer wird normalerweise in einer relativ sauerstofffreien Atmosphäre 30 ppm) gebrannt, obgleich darauf hingewiesen sei, daß Sauerstoffkonzentrationen von mehr als 10 ppb zu einer Oxidation bei den hier interessierenden Temperaturen führt. Die spezifischen Widerstände wurden an einer Leitung gemessen, deren Breite 230 Mikrometer, deren Länge 23 000 Mikrometer und deren durchschnittliche Dicke 5,25 Mikrometer betrug. Der nach Brennen in einer $H_2/H_2O$-Atmosphäre erzielte spezifische Widerstand wurde zu 2,0±0,2 Mikroohm-cm gemessen.

Haftmessungen wurden mit dem sogenannten Zieh-Test durchgeführt. Bei dieser Prüfung werden Kontaktstifte mit einem aus 62% Blei, 36% Zinn und 2% Silber bestehenden Lot bei etwa 180°C für einige Sekunden an Kontaktflächen der Kupfermetallisierung auf einem Substrat angelötet, das aus Glas der Formel Nr. 12 hergestellt und gemäß der Erfindung gebrannt oder gesintert worden war. Der Durchmesser der Anschlußstifte betrug 760 Mikrometer und der Durchmesser der Anschlußkontakte betrug 1520 Mikrometer. Ziehgeschwindigkeiten von 560 Mikrometern je Minute verursachten keine merklichen Abweichungen in dem Wert der Zugkraft. Eine Gruppe von Messungen ergab im Durchschnitt einen Wert von 4,4 kg und eine andere Gruppe von Messungen ergab im Durchschnitt 5,16 kg Kraft. Die meisten Fehler traten an der Trennfläche zwischen Kupfer und Anschlußstift auf. In manchen Fällen trat der Fehler in der glaskeramischen Schicht unter der Kupferschicht auf, welche sich abhob.

Das bisher beschriebene Verfahren eignet sich für eine Anzahl verschiedener Glas-Keramik/Kupfersubstrate, bei denen die Kristallisationstemperatur des Glases etwa 100°C bis 150°C unter dem Schmelzpunkt von Kupfer liegt. Solche Gläser sind beispielsweise in der oben genannten US-Patentanmeldung 875 703 fenbart und haben nach Gewichtsprozent die folgenden Zusammensetzungen:

Glas Nr. 11

| | |
|---|---|
| $SiO_2$ | 52,5 |
| $MgO$ | 22,0 |
| $Al_2O_3$ | 22,0 |
| $P_2O_5$ | 2,0 |
| $B_2O_3$ | 1,0 |
| $ZrO_2$ | 2,0 |

Glas Nr. 12

| | |
|---|---|
| $SiO_2$ | 52,5 |
| $MgO$ | 22,0 |
| $Al_2O_3$ | 22,0 |
| $P_2O_5$ | 1,5 |
| $ZrO_2$ | 1,5 |
| $B_2O_3$ | 0,5 |

Glas Nr. 14

| | |
|---|---|
| $SiO_2$ | 52,5 |
| $MgO$ | 22,0 |
| $Al_2O_3$ | 22,0 |
| $P_2O_5$ | 2,0 |
| $B_2O_3$ | 1,0 |
| $ZnO$ | 1,0 |

Glas Nr. 16

| | |
|---|---|
| $SiO_2$ | 52,5 |
| $MgO$ | 23,5 |
| $Al_2O_3$ | 21,0 |

| | |
|---|---|
| B₂O₃ | 1,0 |
| SnO₂ | 2,0 |

wobei jedes dieser Gläser eine Ausbrenntemperatur für das Bindemittel von 785 ± 10° C aufweist, und

Glas Nr. 10

| | |
|---|---|
| SiO₂ | 50,6 |
| MgO | 24,2 |
| Al₂O₃ | 21,2 |
| P₂O₅ | 2,0 |
| B₂O₃ | 2,0 |

das zum Ausbrennen des Bindemittels wegen seiner geringeren Erweichungstemperatur auf 720 ± 10° C aufgeheizt werden kann.

### Derzeit bestes Verfahren zur Durchführung der Erfindung

Das Herstellungsverfahren für mehrschichtige Substrate besteht dabei aus folgenden Schritten:

#### Schritt 1:

Die Scherben des ausgewählten, kristallisierbaren Glases (in diesem Beispiel Glas Nr. 12) wird bis auf eine durchschnittliche Teilchengröße im Bereich von 2 bis 7 Mikrometer gemahlen. Der Mahlvorgang kann in zwei Stufen durchgeführt werden, einem ersten trockenen oder nassen Mahlvorgang bis zu einer Teilchengröße von 400 Mesh, gefolgt von einem weiteren Mahlvorgang mit einem geeigneten organischen Bindemittel und Lösungsmittel, bis die durchschnittliche Teilchengröße soweit verringert ist, daß sie zwischen 2 und 7 Mikrometer liegt und eine ausgießbare oder ausstreichbare Trübe erhalten wird. Man kann auch in einem einstufigen längeren Mahlvorgang die Glasscherben in einem Bindemittel und einem Lösungsmittel so lange mahlen, bis die gewünschten Teilchengröße erhalten werden. In diesem Fall kann ein Filtrieren erforderlich sein, um zu große Teilchen auszusieben.

Beispielsweise sind geeignete Bindemittel Polyvinylbutyralharz mit einem Weichmacher, wie z. B. Dipropylglykoldibenzoat. Andere geeignete Polymere sind Polyvinylformal, Polyvinylchlorid, Polyvinylacetat, ausgewählte Acrylharze und dergleichen. In gleicher Weise können andere geeignete Weichmacher, wie z. B. Dioctylphthalat, Dibutylphthalat und dergleichen eingesetzt werden.

Der Grund für die Beimischung eines leicht verdampfbaren Lösungsmittels liegt zunächst darin, das Bindemittel aufzulösen, so daß es die einzelnen Glasteilchen überziehen kann, und zweitens zum Einstellen der Viskosität der Trübe für ein gutes Verstreichen oder Ausgießen. Ein für diesen Zweck besonders wirksames Lösungsmittel besteht in den dualen Lösungssystemen, insbesondere dem dualen Methanol/Methylisobutylketon-Lösungssystem mit einem Gewichtsverhältnis von 1/3.

#### Schritt 2:

Die gemäß Schritt 1 hergestellte Trübe wird ausgegossen oder verstrichen und gemäß üblichen Verfahren, vorzugsweis mit einer Rakel zu grünen Folien mit einer Dicke von etwa 200 bis 250 Mikrometern ausgewalzt.

#### Schritt 3:

Die so hergestellten grünen Folien werden für die erforderlichen Abmessungen zurechtgeschnitten, und es werden durchgehende Bohrungen an den erforderlichen Stellen hergestellt.

#### Schritt 4:

Eine kupferhaltige Metallisierungspaste wird in den einzelnen grünen Folien in die durchgehenden Bohrungen eingebracht.

#### Schritt 5:

Eine geeignete Kupferpaste wird dann auf die gemäß Schritt 4 vorbereiteten einzelnen grünen Folien entsprechend den gewünschten Leitungsmustern durch Siebdruck aufgebracht.

#### Schritt 6:

Eine Anzahl gemäß Schritt 5 vorbereiteter grüner Folien wird in einer Laminierpresse miteinander ausgerichtet und laminiert. Die für die Laminierung verwendete Temperatur und der dabei angewandte Druck sollten so gewählt sein, daß die einzelnen grünen Folien sich miteinander verbinden und ein monolithisches grünes Substrat bilden und außerdem bewirken, daß das grüne keramische Material die Leitungsmuster ausreichend umfließt und umschließt.

#### Schritt 7:

Brennen des Laminats bis zur Sintertemperatur für die Entfernung des Bindemittels, sintern oder schmelzen der Glasteilchen und umwandeln der glaskeramischen Masse durch Kristallisation mit gleichzeitigem Sintern der Metallteilchen in den Leitungsmustern zu dichten Kupferleitungen und durchgehend metallisierten Bohrungen.

Ein typischer Zeitablauf eines Brennvorgangs zeigt ebenfalls Fig. 3. Für dieses Beispiel wird das grüne Laminat in einer Stickstoffatmosphäre für etwa $1^1/2$ Stunden mit einer Geschwindigkeit von 2,15°C je Minute auf eine Temperatur von etwa 200°C gebracht. An diesem Punkt wird der Stickstoff durch eine $H_2/H_2O$-Atmosphäre mit einem Volumverhältnis von $10^{-6,5}$ ersetzt. Die Aufheizung wird dann bis auf etwa 450°C fortgesetzt, wo dann die Aufheizgeschwindigkeit auf 2,9°C je Minute erhöht und die Aufheizung bis zum Erreichen einer Haltetemperatur von etwa 780°C fortgesetzt wird (z. B. etwa 2 Stunden). Nach etwa 6 Stunden bei der Haltetemperatur von 780°C wird die $H_2/H_2O$-Atmosphäre gegen eine Stickstoffatmosphäre ausgetauscht und die Haltetemperatur von 780°C wird für eine weitere halbe Stunde aufrechterhalten, worauf dann die Erwärmung weiter fortgesetzt wird mit einer Geschwindigkeit von 2,1°C je Minute bis auf die Kristallisationstemperatur des Glases (z. B. etwa 960°C für das Glas Nr. 12), wobei diese Temperatur dann für 2 Stunden beibehalten wird und anschließend mit einer Geschwindigkeit von etwa 3,8°C je Minute auf Raumtemperatur abgesenkt wird.

Während der $9^1/2$stündigen Dauer der Behandlung in $H_2/H_2O$-Atmosphäre wird deren Volumverhältnis kontinuierlich von $10^{-6,5}$ nach $10^{-4}$ geändert, d. h. erhöht.

Fig. 4 zeigt wiederum das vereinfachte Verfahren für den Brennzyklus, das praktisch das gleiche ist, jedoch mit der Ausnahme, daß die ursprüngliche Stickstoffatmosphäre bis zum Erreichen der Ausbrenntemperatur (z. B. etwa 780°C) beibehalten wird, worauf dann die Atmosphäre gegen eine $H_2/H_2O$-Atmosphäre mit einem Volumenverhältnis von $10^{-4}$ ausgetauscht wird, die für die Zeit des Ausbrennens des Bindemittels (z. B. etwa 6 Stunden) im wesentlichen konstant gehalten wird, bevor der erneute Austausch gegen eine Stickstoffatmosphäre erfolgt, worauf dann bei fortdauernder Wärmezufuhr die Haltetemperatur (780°C) für eine weitere halbe Stunde zum Austreiben von $H_2O$ aufrechterhalten wird, worauf dann die weitere Aufheizung und Halteperiode bei der Kristallisationstemperatur des Glases genau die gleiche ist wie in Fig. 3.

**Patentansprüche**

1. Verfahren zum Herstellen eines glaskeramischen Substrats mit einer auf Kupfer basierenden Metallisierung, gekennzeichnet durch folgende Verfahrensschritte:

Bilden mindestens einer grünen Folie, die aus einem thermolastischen, organischen Bindemittel und darin fein verteilten Teilchen eines kristallisierbaren Glases mit einer Kristallisationstemperatur unterhalb des Schmelzpunktes von Kupfer besteht, Herstellen eines auf der Basis von Kupfer aufgebauten Leitungsmusters auf der Oberfläche der grünen Folie,

Aufbringen einer zweiten grünen Folie über der so behandelten ersten grünen Folie und Laminieren dieser Folien miteinander, Aufheizen dieses Laminats in einer Atmosphäre von Wasserstoff und $H_2O$ mit einem Verhältnis von $H_2/H_2O$ von etwa $10^{-4}$ bis etwa $10^{-6,5}$ bis zu einer Ausbrenntemperatur im Bereich zwischen dem oberen Kühlpunkt und dem Erweichungspunkt des Glases und Aufrechterhalten dieser Temperatur solange, bis das Bindemittel zersetzt und entfernt ist,

Austauschen der $H_2/H_2O$-Atmosphäre durch eine inerte Atmosphäre,

Aufheizen des Laminats bis zur Kristallisationstemperatur des Glases für ein Verschmelzen und Kristallisieren der Glasteilchen zu einer glaskeramischen Struktur mit einem innen liegenden Leitungsmuster auf der Basis von Kupfer.

2. Verfahren nach Anspruch 1, dadurch gekennzeichnet, daß eine Glaszusammensetzung mit der folgenden Formel in Gewichtsprozent verwendet wird

| | |
|---|---|
| MgO | 22—24,2 |
| $SiO_2$ | 50,6—52,5 |
| $B_2O_3$ | 0,5—2 |
| $SnO_2$ | 0—2 |
| $Al_2O_3$ | 21—22 |
| $P_2O_5$ | 0—2 |
| $ZrO_2$ | 0—2 |

3. Verfahren nach Anspruch 1, dadurch gekennzeichnet, daß das Leitungsmuster für eine Befestigung von integrierten Halbleiterplättchen mindestens bis an eine Oberfläche des gebrannten Laminats erstreckt wird.

4. Verfahren nach Anspruch 1, dadurch gekennzeichnet, daß das Glas aus der Beta-Spodumen oder Cordierit-Gläser enthaltenden Gruppe ausgewählt wird.

5. Verfahren nach Anspruch 4, dadurch gekennzeichnet, daß das Laminat zum Austreiben oder Ausbrennen des Bindemittels in der $H_2/H_2O$-Atmosphäre auf eine Ausbrenntemperatur im Bereich zwischen 720°C±10°C und etwa 785°C±10°C aufgeheizt wird.

6. Verfahren nach Anspruch 5, dadurch gekennzeichnet, daß das Laminat mit einer Geschwindigkeit von 1°C bis 3°C pro Minute auf die Ausbrenntemperatur aufgeheizt wird.

7. Verfahren nach Anspruch 5, dadurch gekennzeichnet, daß das Verhältnis in der $H_2/H_2O$-Atmosphäre über die Aufheizung in dieser Atmosphäre kontinuierlich von etwa $10^{-6,5}$ bis etwa $10^{-4}$ verändert wird.

8. Verfahren nach Anspruch 7, dadurch gekennzeichnet, daß das Laminat vor dem Aufheizen in der $H_2/H_2O$-Atmosphäre in einer inerten Atmosphäre auf etwa 100°C aufgeheizt wird.

9. Verfahren nach Anspruch 5, dadurch gekennzeichnet, daß das Verhältnis $H_2/H_2O$ während der Dauer der Aufheizung in dieser Atmosphäre auf etwa $10^{-4}$ gehalten wird.

10. Verfahren nach Anspruch 9, dadurch gekennzeichnet, daß das Laminat zunächst in einer inerten Atmosphäre auf die Ausbrenntemperatur aufgeheizt wird, bevor es in der $H_2/H_2O$-Atmosphäre zum Ausbrennen des Bindemittels bei dieser Temperatur gehalten wird.

11. Verfahren nach Anspruch 4, dadurch gekennzeichnet, daß die Kristallisationstemperatur bei etwa 920° C bis 970° C liegt.

12. Verfahren nach Anspruch 11, dadurch gekennzeichnet, daß das Laminat mit einer Geschwindigkeit von etwa 1° C bis 3° C pro Minute auf die Kristallisationstemperatur aufgeheizt wird.

13. Verfahren nach Anspruch 1, dadurch gekennzeichnet, daß das glaskeramische Material aus den $Li_2O \cdot Al_2O_3 \cdot 4\,SiO_2$ Beta-Spodumen oder $2\,MgO \cdot 2\,Al_2O_3 \cdot 5\,SiO_2$ Alpha-Cordierit enthaltenden kristallinen Phasen ausgewählt wird.

## Claims

1. A method of forming a glass-ceramic substrate with a copperbased metallurgy, characterised by the following steps:

forming at least one green sheet comprised of a thermoplastic organic binder having dispersed therein particles of a crystallizable glass having a crystallization temperature below the melting point of copper;
forming on a surface of a first said green sheet a pattern of a copper based conductor forming composition;
superimposing a second said sheet on said surface of said first sheet;
laminating said superimposed sheets together;
heating said laminate in an ambient of hydrogen and $H_2O$ in a ratio of $H_2/H_2O =$ about $10^{-4}$ to about $10^{-6.5}$ to a burn-out temperature in the range between the anneal and softening points of said glass;
maintaining this temperature for sufficient time to decompose and eliminate binder;
substituting an inert atmosphere for said ambient; and
heating said laminate to the crystallization temperature of said glass for coalescene of said glass particles and crystallization thereof into a glass-ceramic structure having a copper-based conductor pattern extending within the interior thereof.

2. The method of claim 1 wherein said glass particles have the composition, by weight percent,

| | |
|---|---|
| MgO | 22 to 24.2 |
| $SiO_2$ | 50.6 to 52.5 |
| $B_2O_3$ | 0.5 to 2 |
| $SnO_2$ | 0 to 2 |
| $Al_2O_3$ | 21 to 22 |
| $P_2O_5$ | 0 to 2 |
| $ZrO_2$ | 0 to 2 |

3. The method of claim 1 including providing means for extending said pattern to at least one surface of said fired laminate.

4. The method of claim 1 wherein said glass is selected from the group of $\beta$-spodumene or cordierite glasses.

5. The method of claim 4 wherein said laminate is heated in said ambient to a burn-out temperature in the range of about $720 \pm 10$ to about $785 \pm 10°$ C.

6. The method of claim 5 wherein said laminate is heated to said burn-out temperature at a rate of about 1 to 3° C per minute.

7. The method of claim 5 wherein the $H_2/H_2O$ ration of said ambient is continuously changed from about $10^{-6.5}$ to about $10^{-4}$ over the course of said heating in said ambient.

8. The method of claim 7 wherein said laminate is preheated in an inert atmosphere to a temperature of about 100° C Prior to heating in said ambient.

9. The method of claim 5 wherein the $H_2/H_2O$ ratio of said ambient is about $10^{-4}$ over the course of said heating in said ambient.

10. The method of claim 9 wherein laminate is preheated in an inert atmosphere to said burn-out temperature prior to maintenance thereat in said ambient for burn-out of said binder.

11. The method of claim 4 wherein said crystallization temperature is in the range of about 920 to about 970° C.

12. The method of claim 11 wherein said laminate is heated to said crystallization temperature at a rate of about 1 to 3° C per minute.

13. The method of claim 1 wherein said glass-ceramic selected from the group having $Li_2O \cdot Al_2O_3 \cdot 4\,SiO_2$ $\beta$-spodumene or $2\,MgO \cdot 2\,Al_2O_3 \cdot 5\,SiO_2$ alphacordierite crystalline phases.

## Revendications

1. Procédé pour fabriquer un substrat en verre-céramique avec une métallisation à base de cuivre, caractérisé en ce qu'il comporte les étapes suivantes:

formation d'au moins une feuille crue composée d'un liant organique thermoplastique contenant des particules finement dispersée d'un verre cristallisable dont la température de cristallisation est située en-dessous du point de fusion du cuivre,
rélisation d'une configuration de conduc-

teurs à base de cuivre sur la surface de la feuille crue,

dépôt d'une seconde feuille crue sur la première feuille crue ainsi traitée,

laminage de ces feuilles pour former un ensemble,

chauffage de cet ensemble laminé dans une atmosphère d'hydrogène et de $H_2O$ dans un rapport de $H_2/H_2O$ d'environ $10^{-4}$ à environ $10^{-6,5}$ et ce, à une température située entre le point de recuit et le point de ramollissement du verre,

maintenance de cette température jusqu'à ce que le liant soit décomposé et éliminé, remplacement de l'atmosphère $H_2/H_2O$ par une atmosphère inerte,

chauffage de l'ensemble laminé à la température de cristallisation du verre en vue de la fusion, et

cristallisation des particules de verre pour obtenir une structure en verre-céramique avec une configuration de conducteurs interne à base de cuivre.

2. Procédé selon la revendication 1, caractérisé en ce que l'on utilise un verre dont la composition, en pourcentage en poids, est la suivante:

| | |
|---|---|
| MgO | 22 à 24,2 |
| $SiO_2$ | 50,6 à 52,5 |
| $B_2O_3$ | 0,5 à 2 |
| $SnO_2$ | 0 à 2 |
| $Al_2O_3$ | 21 à 22 |
| $P_2O_5$ | 0 à 2 |
| $ZrO_2$ | 0 à 2 |

3. Procédé selon la revendication 1, caractérisé en ce que la configuration de conducteurs s'étend au moins jusqu'à la surface de l'ensemble laminé cuit pour la fixation des microplaquettes semi-conductrices intégrées.

4. Procédé selon la revendication 1, caractérisé en ce que la verre est choisi dans le groupe comprenant le $\beta$-spodumène ou les verres de cordiérite.

5. Procédé selon la revendication 4, caractérisé en ce que l'ensemble laminé est chauffé à une température située entre environ $720°C \pm 10°C$ et $785°C \pm 10°C$ pour éliminer ou bruler le liant en atmosphère d'$H_2/H_2O$.

6. Procédé selon la revendication 5, caractérisé en ce que l'ensemble laminé est chauffé jusqu'à la température de brûlage et ce, à une vitesse comprise entre 1°C à 3°C par minute.

7. Procédé selon la revendication 5, caractérisé en ce que le rapport $H_2/H_2O$ de ladite atmosphère varie de façon continue d'environ $10^{-6,5}$ à environ $10^{-4}$ pendant le processus de chauffage dans cette atmosphère.

8. Procédé selon la revendication 7, caractérisé en ce que l'ensemble laminé est chauffé en atmosphère inerte à environ 100°C avant le chauffage dans l'atmosphère $H_2/H_2O$.

9. Procédé selon la revendication 5, caractérisé en ce que le rapport $H_2/H_2O$ est maintenu à environ $10^{-4}$ pendant la durée de l'échauffement dans ladite atmosphère.

10. Procédé selon la revendication 9, caractérisé en ce que l'ensemble laminé est d'abord chauffé dans une atmosphère inerte à la température de brûlage avant d'être maintenu dans une atmosphère $H_2/H_2O$ à cette température en vue d'éliminer le liant.

11. Procédé selon la revendication 4, caractérisé en ce que la température de cristallisation est située entre environ 920°C et 970°C.

12. Procédé selon la revendication 11, caractérisé en ce que l'ensemble laminé est chauffé jusqu'à la température de cristallisation à une vitesse comprise entre environ 1°C et 3°C par minute.

13. Procédé selon la revendication 1, caractérisé en ce que le matériau verre-céramique est choisi dans le groupe comportant les phases cristallines de $Li_2O \cdot Al_2O_3 \cdot 4 SiO_2$ $\beta$-spodumène ou de $2 MgO \cdot 2 Al_2O_3 \cdot 5 SiO_2$ alphacordierite.

**FIG. 1**

LOG $(P_{H_2}/P_{H_2O})$

TEMPERATUR °C

VERRINGERN VON $CO_2$

$C + 2H_2O \cdot CO_2 + 2H_2$

OXIDIEREN VON C

VERRINGERN VON $Cu_2O$

$2Cu + H_2O \cdot Cu_2O + H_2$

OXIDIEREN VON Cu

100 ppm
10 ppm
1 ppm

**FIG. 2**

AUSTREIBEN DES BINDEMITTELS / BEREICH MIT AUFQUELLEN FÜR GLASKERAMIK NR. 12 IN $H_2/H_2O$

× BLASEN
○ WEISS
● GRAU

ZEIT (STD)

TEMPERATUR °C

WEISS

AUFQUELLEN

GRAU

H₂/H₂O ZYKLUS

## FIG. 3

VEREINFACHTER H₂/H₂O ZYKLUS

## FIG. 4